# FASCICULE DE BREVET EUROPEEN

(11) **EP 3 441 734 B1**
(45) Date de publication et mention de la délivrance du brevet: **13.03.2024**
(21) Numéro de dépôt: 18187051.0
(22) Date de dépôt: 02.08.2018
(51) Int. Cl.: G01J 5/04, G01J 5/02, H01L 21/00

(54) **PROCÉDÉ DE FABRICATION D'UN DISPOSITIF DE DÉTECTION À DEUX SUBSTRATS ET UN TEL DISPOSITIF DE DÉTECTION**
HERSTELLUNGSVERFAHREN EINER DETEKTIONSVORRICHTUNG MIT ZWEI SUBSTRATEN, UND EINE SOLCHE DETEKTIONSVORRICHTUNG
METHOD FOR MANUFACTURING A DETECTION DEVICE HAVING TWO SUBSTRATES AND SUCH A DETECTION DEVICE

(30) Priorité: 08.08.2017 FR 1757589
(43) Date de publication de la demande: 13.02.2019
(73) Titulaire: Commissariat à l'énergie atomique et aux énergies alternatives, 75015 Paris (FR)
(72) Inventeur: LEDUC, Patrick, 38000 Grenoble (FR)
(74) Mandataire: Brevalex

(56) Documents cités:
- WO-A1-2014/044463
- US-A1- 2011 155 914
- US-A1- 2013 056 733
- US-A1- 2016 221 819

## Description

### DOMAINE TECHNIQUE

L'invention concerne le domaine de la détection de rayonnements électromagnétique tels que les rayonnements électromagnétiques dont la longueur d'onde est comprise dans la gamme des infrarouges, et vise plus particulièrement les dispositifs de détection permettant une telle détection.

L'invention a ainsi plus précisément pour objet un procédé de fabrication d'un dispositif de détection de rayonnements électromagnétiques et un dispositif de détection de rayonnements électromagnétiques.

### ÉTAT DE LA TECHNIQUE ANTÉRIEURE

Afin d'améliorer la sensibilité des structures de détection de certains dispositifs de détection, notamment ceux destinés à la détection de rayonnements électromagnétiques dont la longueur d'onde est comprise dans la gamme des infrarouges, il est connu de loger les structures de détection de ces dispositif dans une cavité sous vide au moins primaire. Dans une telle configuration, les structures sont alors isolées thermiquement du reste du dispositif au moyen de bras de connexion qui font office de soutiens de ladite structure et qui permettent sa connexion électrique.

Lorsque cela est le cas, le procédé de fabrication d'un tel dispositif de détection en est complexifié vis-à-vis de ceux permettant la fabrication de structures simplement encapsulées dans un diélectrique, ceci en particulier pour les microbolomètres à base de transistor ou de diode .

En effet, la formation de tels dispositifs, que sont les microbolomètres à base de transistor ou de diode, nécessite généralement l'utilisation de trois substrats différents assemblés ensemble, l'un comportant le circuit de lecture, le deuxième comportant les structures de détection et le troisième comportant le capot. Le document US 20130026592 décrit un tel procédé de fabrication.

Le procédé de fabrication selon le document US 20130026592 comprend ainsi les étapes suivantes :
- fourniture d'un premier substrat intégrant un circuit de lecture, le premier substrat comprenant en outre au moins deux premiers plots de contact reliés au circuit de lecture,
- fourniture d'un deuxième substrat comportant :
   ∘ un support,
   ∘ au moins une structure de détection, pour la détection de rayonnements électromagnétiques, munie d'au moins deux bras de connexion se prolongeant chacun par un deuxième plot de contact complémentaire à un premier plot de contact correspondant, la structure de détection étant disposée sur le support,
   ∘ un matériau sacrificiel déposé sur le support et enfermant la structure de détection de telle manière à ce que les deuxièmes plots de contact soient chacun au moins en partie exposés
- collage du deuxième substrat sur le premier substrat avec chacun des deuxièmes plots de contact collés sur le premier plot de contact correspondant,
- suppression du support,
- ouverture d'une tranchée dans le matériau sacrificiel entourant la structu re,
- formation dans la tranchée d'une paroi latérale entourant la structure de détection,
- suppression du matériau sacrificiel de manière à libérer la structure de détection,
- fourniture d'un troisième substrat destiné à former un capot,
- assemblage du troisième substrat sur la paroi latérale afin de former avec cette dernière une cavité enfermant la structure de détection, l'assemblage se faisant sous un vide au moins primaire.

Avec un tel procédé il est donc possible de former un dispositif de détection comportant une structure présentant une bonne isolation thermique vis-à-vis du reste du dispositif puisque, outre la connexion thermique fournie par les bras de connexion de la structure, la structure est isolée par le vide réalisé dans la cavité formée par le premier substrat, la paroi latérale et le troisième substrat.

Ainsi, si un tel procédé permet de fournir un dispositif de détection avec une sensibilité accrue, il présente néanmoins l'inconvénient d'être relativement complexe puisqu'il nécessite l'assemblage de trois substrats, le premier intégrant le circuit de lecture, le deuxième utilisé pour la fourniture de la structure et le troisième pour former le capot.

Il est également connu du document US 2011/155914 de fournir un dispositif de détection de rayonnement à base de photopiles encapsulés entre une couche de nitrure et une couche d'oxyde et du document WO2014/044463 de fournir un dispositif en combinant deux supports, l'un comportant un réseau de capteur et l'autre comportant un circuit intégré.

### EXPOSÉ DE L'INVENTION

L'invention vise à remédier à cet inconvénient et a ainsi notamment pour objet de fournir un procédé de fabrication d'un dispositif de détection qui, permettant de fournir un dispositif de détection comportant une structure de détection isolée thermiquement du reste du dispositif de détection, est plus simple vis-à-vis des procédés de fabrication de l'art antérieur.

L'invention concerne à cet effet un procédé de fabrication d'un dispositif de détection de rayonnements électromagnétiques selon la revendication 1.

Avec un tel procédé, la structure de détection, la paroi latérale et le capot sont fournis au moyen du seul deuxième substrat, il n'est donc pas nécessaire d'utiliser un troisième substrat. Le procédé de fabrication selon l'invention permet donc d'obtenir un dispositif de détection dont la ou les structure de détection isolée thermiquement du reste du dispositif de détection sans faire appel à un troisième substrat. Le procédé de fabrication selon l'invention est donc simplifié vis-à-vis de ceux de l'art antérieur.

On notera également, que l'invention présente également comme avantage de :
- permettre la fourniture d'une paroi latérale de faible épaisseur, ce en raison de l'utilisation du matériau sacrificiel et de la possibilité de pouvoir réaliser la paroi latérale annulaire dans des matériaux autres que des matériaux semiconducteurs,
- autoriser la fourniture d'un capot de faible épaisseur, c'est-à-dire inférieur à 50 µm, puisque le procédé est compatible avec une étape d'amincissement du capot, tel qu'une étape de gravure ou une étape de polissage.

Concernant les terminologies de « paroi latérale annulaire » et de « élément de collage annulaire », le terme « annulaire » doit être entendu en ce que ladite paroi latérale, ou ledit élément de collage, s'étend selon une ligne courbe fermée et ne sous-entend aucunement que la forme de ladite courbe fermée est circulaire. Ainsi chacun de la paroi annulaire et de l'élément de collage annulaire peut aussi bien s'étendre selon un cercle que selon un carré, un hexagone, un quelconque polygone ou tout autre forme, sous réserve que celle-ci corresponde à une ligne courbe fermée.

Par « matériau sacrificiel », il doit être entendu ci-dessus et dans le reste de ce document, et ceci conformément à l'entendement de l'homme du métier, que le matériau est apte à être gravé sélectivement, les autres éléments du dispositif intermédiaire soumis à ladite gravure sélective , tels que la structure de détection et les bras de connexion contenu dans ledit matériau sacrificiel, n'étant pas gravé par ladite gravure sélective soit en raison de leur composition soit en raison de la présence d'une couche de protection non attaqué par ladite gravure sélective.

Bien entendu, si chacun des bras de connexion se prolonge par un deuxième plot de contact respectif, cela n'exclut nullement qu'un tel plot de contact, également connu par l'homme du métier sous la dénomination de « clou », ne soit pas commun avec un bras de connexion d'une structure adjacente à la structure comportant ledit bras.

Le procédé peut comporter en outre une étape d'amincissement du capot.

Avec une telle possibilité, il est possible de former un composant selon l'invention avec un capot particulièrement mince. De cette manière il est possible d'optimiser le taux de transmission du capot et donc la sensibilité de la structure de détection.

La paroi latérale annulaire peut comporter au moins une sous-paroi réalisée dans un matériau sélectionné parmi le cuivre, le silicium et le tungstène.

Une telle sous-paroi permet d'assurer une bonne étanchéité de la cavité.

La paroi latérale annulaire peut comporter au moins une couche barrière adaptée pour contenir la diffusion d'une partie d'au moins un matériau constitutif de la paroi latérale annulaire, ladite couche barrière étant préférentiellement réalisée dans un matériau sélectionné parmi un nitrure de titane, un alliage de titane tungstène et un nitrure de tantale.

Avec une telle couche barrière, il est possible d'utiliser des matériaux tels que le cuivre, et le tungstène sans que cela soit risque de perturbation pour le fonctionnement du dispositif puisque lesdits matériaux sont contenus par la couche barrière.

Lors de l'étape de fourniture du premier substrat, il peut être prévu au moins deux premier éléments de collage annulaire selon une configuration gigogne,
lors de l'étape de fourniture du deuxième substrat, la paroi latérale annulaire peut comprendre au moins deux sous-parois selon une configuration gigogne correspondant chacune à un premier élément de collage annulaire respectif, chacune des sous-parois comportant un deuxième élément de collage annulaire correspondante audit premier élément de collage annulaire respectif,
et lors de l'étape de collage de la deuxième surface du deuxième substrat sur la première surface du premier substrat, chacun des deuxièmes éléments de collage annulaires peut être collé sur le premier élément de collage annulaire correspondant.

Avec une telle configuration comprenant une pluralité de sous-parois dans une configuration gigogne, il est possible de fournir une cavité présentant une bonne étanchéité puisque celle-ci est assurée par chacune des sous-parois de la paroi latérale annulaire. On notera qu'une telle configuration assure également une bonne rigidité ceci avec une quantité de matériau moindre, ceci en prenant en compte les contraintes de conception de la microélectronique.

Lors de la fourniture du deuxième substrat, le capot peut comporter en outre un matériau de renfort dans un espace entre les sous-parois.

Un tel matériau de renfort permet d'assurer une bonne cohésion entre les sous-parois tout en assurant une bonne étanchéité.

Le deuxième substrat comporte en outre une embase, ladite embase comportant la deuxième surface du substrat et permettant de fermer la cavité formée par le capot et l'au moins une paroi latérale annulaire,
dans lequel les deuxièmes plots de contact et le deuxième élément de collage annulaire sont au moins en partie inclus dans l'embase.

Avec une telle embase, la cavité est entièrement formée dans le deuxième substrat et est donc déjà fermée avant le collage sur le premier substrat. Ainsi, avec cette configuration, le collage sur le premier substrat permet de parfaire l'étanchéité de la cavité, celle-ci étant fermée par l'embase et par le premier substrat.

Lors des étapes de fourniture du premier et du deuxième substrat au moins l'un du premier et du deuxième substrat peut comporter au moins une couche de matériau sorbeur avec un agencement adapté pour qu'après collage du deuxième substrat sur le premier substrat et la suppression sélective du matériau sacrificiel, ladite couche de matériau sorbeur communique avec la cavité.

Un tel matériau sorbeur permet de garantir la qualité du vide dans la cavité tout au long de la durée de vie du dispositif.

Lors de l'étape de fourniture du deuxième substrat, la structure de détection peut être un transistor MOS-FET.

Un tel procédé de fabrication est particulièrement avantageux pour la fourniture d'un dispositif comprenant un transistor MOS-FET puisqu'il nécessite de faire appel qu'à deux substrats contrairement au procédé de l'art antérieur qui en nécessitent trois.

L'étape de fourniture du deuxième substrat peut comporter les sous-étapes suivantes :
- fourniture d'un substrat du type couche semiconductrice sur isolant, le substrat du type cous semiconductrice sur isolant comprenant un support, une couche d'isolant formé d'un matériau sacrificiel et une couche semiconductrice,
- suppression sélective d'une partie de la couche semiconductrice afin de délimiter une portion de couche correspondant à la surface du transistor MOS-FET,
- implantation localisée d'élément dopant d'un premier type de conductivité dans la portion de couches semiconductrices, d'une première et d'une deuxième zone semiconductrice, les première et deuxième zone semiconductrice étant séparée l'une de l'autre par une troisième zone semiconductrice non implantée,
- dépôt localisé d'une couche isolante recouvrant au moins la troisième zone semiconductrice,
- dépôt localisé d'une couche d'absorption en contact avec la couche isolante avec un agencement rendant la couche d'absorption apte à polariser la troisième zone semiconductrice,
- dépôt d'une couche de protection recouvrant couche d'absorption et les parties de la couche isolante exposées,
- dépôt d'une première couche de matériau sacrificiel, la première couche de matériau sacrificiel enfermant la couche semiconductrice, la couche isolante, la couche d'absorption et la couche de protection,
- formation du premier et du deuxième bras de connexion comportant respectivement la première et la deuxième piste de connexion pour permettre la polarisation du transistor, la première piste de connexion étant connectée à la deuxième zone, la deuxième piste de connexion étant connectée à la première zone et à la couche d'absorption en les mettant en court-circuit,
- dépôt d'une deuxième couche de matériau sacrificiel, la deuxième couche de matériau sacrificiel enfermant le premier et le deuxième bras de connexion,
- formation de la paroi latérale annulaire au travers de la couche de matériau diélectrique et des première et deuxième couches de matériau sacrificiel, la paroi latérale annulaire étant en contact avec le support de manière à former avec le support une cavité,
- formation du deuxième élément de collage annulaire et des deuxièmes plots de contact de manière à former le deuxième substrat (ceci avec les deuxièmes plots de contact et le deuxième élément de collage annulaire au moins en partie exposés sur la deuxième surface du deuxième substrat.

Lors de la sous-étape de fourniture d'un substrat du type couche semiconductrice sur isolant de l'étape de fourniture du deuxième substrat, le support comprend un traitement optique.

Un tel traitement optique permet d'optimiser le taux de transmission du capot du dispositif qui est formé lors de la mise en oeuvre du procédé selon l'invention.

L'invention concerne en outre un dispositif de détection de rayonnements électromagnétiques selon la revendication 11.

Un tel dispositif est aisé à obtenir puisqu'il peut être obtenu au moyen du procédé selon l'invention. Il n'est donc nécessaire que deux substrats pour le former, ce qui permet de réduire les coûts de fabrication.

Le capot peut présenter une épaisseur comprise entre 1 µm et 100 µm, préférentiellement comprise entre 5 µm et 50 µm et avantageusement entre 10 µm et 30 µm.

Avec un tel capot, le dispositif présente une sensibilité optimisée, puisque le taux de transmission du rayonnement électromagnétique par le capot en direction de la structure de détection est lui-même optimisé.

La paroi latérale annulaire peut comporter au moins deux sous-parois selon une configuration gigogne.

Avec une telle configuration de la paroi latérale annulaire, le dispositif comporte une cavité présentant une bonne étanchéité puisque celle-ci est assurée par chacune des sous-parois.

La structure de détection peut être un transistor MOS-FET.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre une vue en coupe longitudinale schématique d'un dispositif de détection selon un premier mode de réalisation de l'invention,
- les figures 2A à 2D illustrent respectivement une vue de dessus, une vue en coupe selon la ligne de coupe A-A, une vue en coupe selon la ligne de coupe B-B et une vue de dessus en coupe selon la ligne de coupe C-C d'une structure de détection équipant un dispositif selon l'invention,
- la figure 3 illustre un premier substrat utilisé lors de la mise en oeuvre d'un procédé de fabrication du dispositif de détection selon le premier mode de réalisation de l'invention
- la figure 4A et 4B illustre respectivement un deuxième substrat utilisé lors de la mise en oeuvre du procédé de fabrication d'un dispositif selon le premier mode réalisation de l'invention et un support utilisé pour la formation dudit deuxième substrat,
- la figure 5 illustre un support pour la formation d'un deuxième substrat du dispositif selon un deuxième mode réalisation dans lequel le support est dépourvu de couche intermédiaire d'arrêt et de traitement optique,
- la figure 6 illustre schématiquement une vue de dessus d'un dispositif de détection selon l'invention montrant un exemple d'agencement des structures de détection,
- la figure 7 illustre schématiquement les parois latérales annulaires d'un dispositif de détection selon une variante de l'invention dans laquelle lesdites parois latérales sont renforcées au moyen de piliers de renfort interne.

Des parties identiques, similaires ou équivalentes des différentes figures portent les mêmes références numériques de façon à faciliter le passage d'une figure à l'autre.

Les différentes parties représentées sur les figures ne le sont pas selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

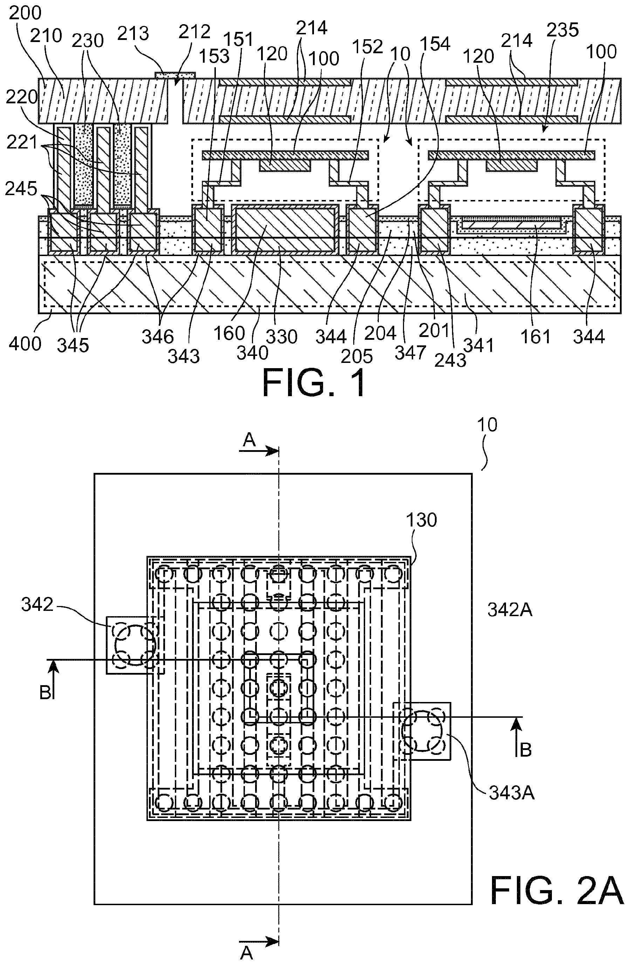

La figure 1 illustre un dispositif de détection 1 selon l'invention pour la détection de rayonnements électromagnétiques.

L'invention vise en particulier les dispositifs de détection dédiés à la détection de rayonnements électromagnétiques dont la longueur d'onde est comprise dans la gamme de longueurs d'onde des infrarouges. Ainsi, les différentes valeurs indiquées dans les modes de réalisation décrits ci-après concernent une application pratique dans laquelle la gamme de longueurs d'onde visée est l'infrarouge lointain, c'est-à-dire entre 8 et 12 µm. Bien entendu, l'homme du métier est parfaitement à même, à partir de la présente divulgation, d'adapter ces valeurs afin de permettre à l'aide d'une telle structure de détection 10 la détection optimisée de rayonnements électromagnétiques dans une gamme de longueurs d'onde autre, que celle-ci soit comprise dans les infrarouges ou non.

Un tel dispositif de détection 1 de rayonnements électromagnétiques comporte :
- un premier substrat 341, le premier substrat 341 intégrant un circuit de lecture 340 et comportant une première et une deuxième surface, le premier substrat 341 comprenant en outre des premiers plots de contact 343, 344 reliés au circuit de lecture 340 et trois premiers éléments de collage annulaires 345 entourant les premiers plots de contact 343, 344, les premiers plots de contact 343, 344 et les premiers éléments de collage annulaires 345 étant chacun au moins en partie exposés sur la première surface du premier substrat 341,
- une pluralité de structures de détection 10, pour la détection de rayonnements électromagnétiques, munies chacune d'au moins deux bras de connexion 151, 152 se prolongeant chacun par un deuxième plot de contact 153, 154 complémentaire à un premier plot de contact 343, 344 correspondant, chacun des deuxièmes plots de contact 153, 154 étant collé au premier plot de contact 343, 344 correspondant,
- un capot 210, et
- une paroi latérale annulaire 220s'étendant à partir du capot 210, le capot et la paroi latérale annulaires 220 formant ensemble une cavité logeant les structures de détection 10, la paroi latérale annulaire 220 comportant trois sous-parois 221 concentrique et chacune de ce sous-parois 221 étant munie, sur une extrémité opposée au capot 210, d'un deuxième élément de collage annulaire 245 complémentaire au premier élément de collage annulaire 345, chacun des deuxièmes éléments de collage annulaires 245 étant collé au premier élément de collage annulaire 345 correspondant, le capot 210 et la paroi latérale annulaire 220 formant une cavité fermée présentant un vide au moins primaire.

Il est à noter que dans le cadre de la présente description de l'invention, chacune des structures de détection 10 décrite est un transistor 100 du type MOS-FET. Bien entendu, l'invention ne se limite pas à ce seul type de structures de détection, l'homme du métier étant à même, à partir de l'enseignement du présent document et de ses connaissances générales, d'appliquer l'invention à tout type de structures de détection. L'invention peut s'appliquer ainsi également, en particulier et de manière non limitative, aux bolomètres et aux photodiodes.

Par transistor MOS-FET, terminologie généralement utilisée par l'homme du métier, il est entendu ci-dessus et dans le reste de ce document, transistor à effet de champ du type métal/oxide/semconducteur. En effet, le sigle MOS-FET a pour origine la terminologie anglaise « Metal-Oxyde-Semiconductor Field Effect Transistor ».

On notera également que si la paroi latérale annulaire 220 comporte dans ce premier mode de réalisation trois sous-parois 221, elle peut bien entendu en comporter un nombre différent sans que l'on sorte du cadre de l'invention. On notera ainsi, en particulier, que la paroi latérale annulaire 220 peut être formée d'une seule paroi monobloc sans que l'on sorte du cadre de l'invention.

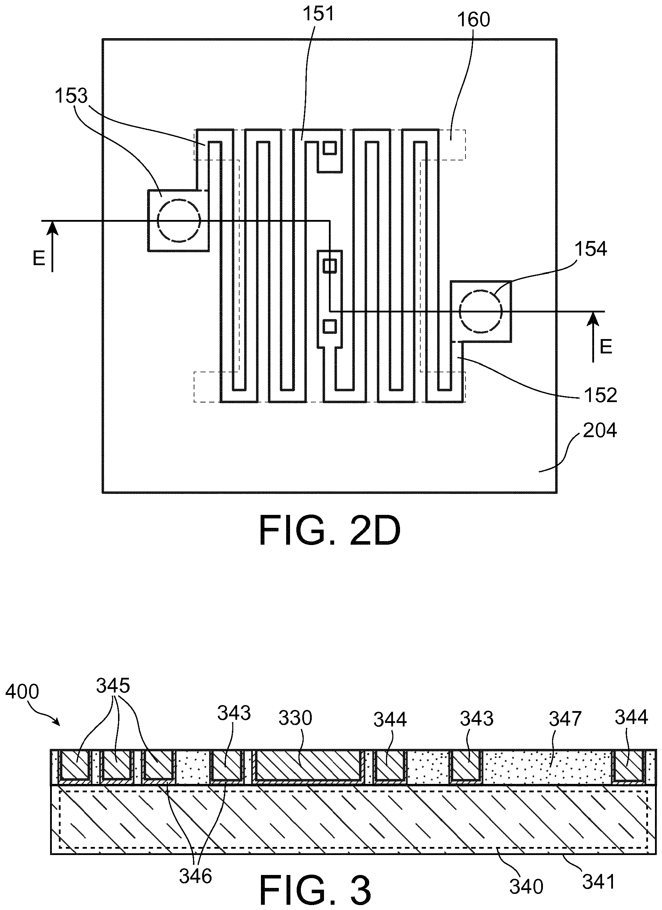

Ainsi dans le cadre de ce mode de réalisation et en référence aux figures 2A à 2D, chacune des structures de détection 10 comporte :
- un transistor 100 du type MOS-FET comportant :
   ∘ au moins une première et au moins une deuxième zone semiconductrice 111, 112 d'un premier type de conductivité,
   ∘ au moins une troisième zone semiconductrice 113 séparant l'une de l'autre la première et la deuxième zone semiconductrice 111, 112, la troisième zone semiconductrice 113 étant d'un type de conductivité dans lequel la troisième zone est sensiblement vide de porteurs, autrement dit la troisième zone semiconductrice 113 est totalement déplétée,
   ∘ une grille 120 agencée pour polariser la troisième zone semiconductrice 113, la grille 120 comportant une première couche diélectrique et une couche d'absorption 125 dans un métal du type « milieu-de-gap » pour la troisième zone, ce métal étant préférentiellement en nitrure de titane TiN et la couche d'absorption 125 formant élément absorbant,
- un premier et un deuxième bras de connexion 151, 152 comportant respectivement une première et une deuxième piste de connexion 162, 165 pour permettre la polarisation du transistor 100, la première piste de connexion 162 étant connectée à la deuxième zone semiconductrice 112, la deuxième piste de connexion 165 étant connectée à la première zone semiconductrice 111 et à la couche d'absorption 125 en les mettant en court-circuit,
- des premier et deuxième deuxièmes plots de contact 153, 154 prolongeant respectivement le premier et le deuxième bras de connexion 151, 152,
- une surface de réflexion 160 disposée de manière à former avec la couche d'absorption 125 une cavité quart-d'onde.

On notera que dans une telle configuration, la première zone semiconductrice 111 forme le drain du transistor, la deuxième zone semiconductrice 112 forme la source du transistor et la troisième zone semiconductrice 113 le canal du transistor 100. Ainsi le transistor 100 fonctionne en faible insertion, le drain et la grille étant en court-circuit et les tensions source-drain V_{SD} et source grille V_{SG} étant égales

Les première au troisième zones semiconductrices 111, 112, 113 sont toutes trois aménagées dans une couche semiconductrice 101 réalisée dans un matériau semiconducteur, tel qu'un silicium Si, un germanium Ge et un carbure de silicium SiC. L'épaisseur de la couche semiconductrice 101est adaptée afin de fournir une troisième zone semiconductrice 113 déplétée.

Par type de conductivité dans lequel la troisième zone semiconductrice 113 est sensiblement vide de porteurs, il doit être entendu ci-dessus et dans le reste de ce document que la troisième zone semiconductrice 113 présente un type de conductivité et une épaisseur tels que, en l'absence de polarisation de la structure de détection 10, la troisième zone semiconductrice 113 est sensiblement vide de porteurs. Bien entendu, en fonctionnement et lors de l'application d'une polarisation sur la couche d'absorption 125, la création d'un canal de conduction permet de peupler la troisième zone semiconductrice 113 de porteurs du premier type de conductivité. On peut noter que pour l'homme du métier l'indication selon laquelle « la troisième zone est déplétée » est synonyme d'un tel type de conductivité dans lequel la troisième zone est sensiblement vide de porteurs.

La couche d'absorption 125 est réalisée dans un métal du type « milieu-de-gap » pour la troisième zone semiconductrice 113, la couche d'absorption 125 étant préférentiellement dans un métal choisie dans le groupe comportant les nitrures de titane, les nitrures de tantale et les siliciures de molybdène pour une troisième zone semiconductrice 113, et donc une couche semiconductrice 101, réalisée en silicium, la couche d'absorption 125 étant avantageusement réalisée dans un nitrure de titaneTiN pour une troisième zone semiconductrice 113 réalisée en silicium.

On entend ci-dessus et dans le reste de ce document par « métal du type milieu-de-gap » que le métal est choisi de manière à présenter, en absence de polarisation de la structure, son énergie de Fermi dans la zone de bande interdite de la troisième zone et plus précisément au voisinage du milieu de la bande interdite de la troisième zone, typiquement à un niveau d'énergie distant du milieu de la bande interdite dans une gamme comprise entre -25% et +25% du gap de la bande interdite. Une telle configuration de grille est généralement connue par l'homme du métier sous la dénomination anglaise de « midgap ». Ainsi dans le cas où la troisième zone est réalisée en silicium, les « métals du type milieu-de-gap » comportent notamment les nitrures de titane, les nitrures de tantale et les siliciures de molybdène.

On peut noter qu'une telle configuration peut notamment être obtenue avec une couche d'absorption 125 en nitrure de titane TiN de 10 nm d'épaisseur.

On notera que selon une variante de l'invention illustrée sur la figure 1, la surface de réflexion 160 peut être substituée par un matériau sorbeur 161, également connu sous la dénomination anglaise de « getter ». Un tel matériau sorbeurest un matériau présentant une surface particulièrement réactive de manière à permettre une chimisorption des éventuels gaz résiduels se trouvant dans la cavité. Il permet ainsi d'assurer un pompage de la cavité pendant toute la durée de vie du dispositif de détection 1 afin d'éviter une éventuelle remontée de pression dans la cavité liée à un dégazage.

De manière particulièrement avantageuse, ce matériau sorbeur 161 peut être adapté pour également former une surface de réflexion avec une disposition adapté pour à former avec la couche d'absorption 125 une cavité quart-d'onde.

Le matériau sorbeur 161 peut être sélectionné dans le groupe comportant le titane, le zirconium, le vanadium, le chrome, le cobalt, le fer, le manganèse, le palladium, le baryum, l'aluminium et leurs alliages.

Chacune des structures de détection est connectée au circuit de lecture 340 au moyen des bras de connexion 151, 152 et des premiers et deuxièmes plots de contact 153, 154, 343, 344 correspondant.

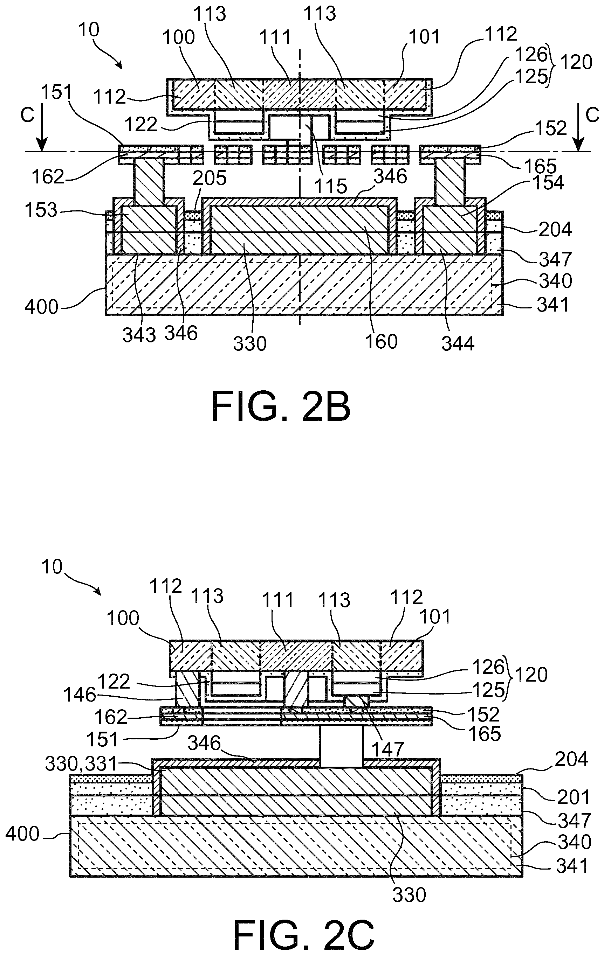

Le circuit de lecture 340 est, comme illustré sur les figures 2B et 2C, aménagé dans le premier substrat 341 qui est un substrat semiconducteur, tel qu'un substrat en silicium, dans lequel sont ménagés les composants du circuit de lecture 340. Le circuit de lecture 340 est configuré pour polariser les structures de détection 10 et pour déterminer, à partir d'un courant de fonctionnement du transistor 100 une élévation de température de la couche d'absorption 125. Un tel circuit de lecture 340 est uniquement figuré au moyen de pointillés représentant son emplacement dans le premier substrat 341. Un tel circuit de lecture 340 est d'un type connu de l'homme du métier et peut ainsi aussi bien comporter une pluralité de sous-circuits de lecture dédiés chacun à un seul transistor 100, qu'un circuit mutualisé pour un groupe ou pour tous les transistors 100 équipant le dispositif de détection 1 ou encore un circuit de lecture 340 composé d'une partie dédiée à un seul transistor 100 et d'une partie mutualisée pour un groupe ou pour tous les transistors 100 équipant le dispositif de détection 1. De tels circuits de lecture 340, généralement de technologie MOS, étant connus de l'homme du métier, ils ne sont pas décrits plus précisément dans ce document.

Bien entendu, conformément aux connaissances de l'homme du métier, ce circuit de lecture est adapté au type de structures de détection 10 équipant le dispositif de détection 1.

Afin d'assurer la connexion entre le circuit de lecture 340 et chacun des transistors 100, le premier substrat 400 comporte, exposé sur la première surface du support semiconducteur 341, des premier et deuxième premiers plots de contact 343, 344. Le premier et le deuxième premier plot de contact 343, 344 sont réalisés dans un matériau métallique adapté pour former un contact ohmique avec le circuit de lecture 340 et pour autoriser un collage des deuxièmes plots de contact 153, 154 sur les premiers plots de contact 343, 344. Ainsi, un tel matériau métallique peut être, par exemple, réalisé en cuivre Cu, en titane Ti ou en tungstène W. Les premiers plots de contact 343, 341, dans le cadre d'une application pratique de l'invention, peuvent présenter une surface de 1 µm par 1 µm.

La première surface du premier substrat 341 est également munie, comme illustré sur la figure 2B, en correspondance avec chacune des structures de détection 10, d'une couche métallique 330 pour permettre la formation d'une portion de collage afin de coller la surface de réflexion 160. Ainsi, chacune des couches métalliques 330 s'étend sur une portion de la première surface du premier substrat 340 qui est en regard de la structure de détection 10 correspondante. On notera que dans l'application pratique de l'invention, la surface occupée par chacune des structures de détection 10 peut être une surface de 5 µm par 5 µm. De la même façon que les premiers plots de contact 343, 344 peuvent être réalisés en cuivre Cu, en titane Ti ou en tungstène W.

Le premier substrat 341 comporte également, comme illustré sur la figure 1, les trois premiers éléments de collage annulaires 345 exposés sur la première surface du premier substrat 341. Les trois premiers éléments de collage annulaires 345 sont réalisés dans un matériau adapté pour autoriser un collage des deuxièmes éléments de collage annulaires 245 sur les premiers éléments de collage annulaires 345. Ainsi les premiers éléments de collage annulaires 345 sont préférentiellement réalisés en cuivre Cu, bien entendu d'autres matériaux sont également envisageables sans que l'on sorte du cadre de l'invention. Plus précisément, les premiers éléments de collage annulaires 345 peuvent être réalisés dans un matériau sélectionné dans le groupe comportant le cuivre Cu, titane Ti, et le tungstène W.

Chacun des premiers éléments de collage annulaires 345 s'étend selon une ligne courbe fermée enfermant les premiers plots de contact 343, 344 et les couches métalliques 330. Les premiers éléments de collage annulaires 345 s'emboîtent les unes avec les autres, avec le premier élément de collage annulaire 345 le plus à l'extérieur qui contient les autres premiers éléments de collage annulaires 345 et avec le premier élément de collage annulaire 345 le plus à l'intérieur qui est contenu par les autres premiers éléments de collage annulaires 345. Ainsi, les premier éléments de collage annulaires 345 présentent une configuration en gigogne.

Les parties de la première surface du premier substrat 400, qui ne comprennent pas le premier et le deuxième plot de connexion 342, 343, les premiers éléments de collage annulaires 345 et la couche métallique 330, comportent une première couche de passivation 347. La première couche de passivation 347 est préférentiellement adaptée pour un collage avec une couche du même type du deuxième substrat 200. On peut noter que selon une possibilité de l'invention, une telle couche de passivation avec chacun de premier et deuxième plots de connexion 342, 343 et de la couche métallique 330 qui affleure de la première surface peut être fournie par un procédé Damascène. La première couche de passivation 347 est réalisée dans un matériau diélectrique tel qu'un dioxyde de silicium SiO₂ ou un nitrure de silicium SiₓN_{y}.

On notera que dans le cadre de la variante de l'invention dans laquelle la surface de réflexion 160 est substituée par un matériau sorbeur 161, il n'est pas prévu de couche métallique 330 et la portion correspondante de la première surface du premier substrat 400 comprend la première couche de passivation 347 comme cela est illustré sur la figure 1.

Il est également à noter que dans le cas où au moins l'un parmi les premiers plots de contact 343,344, les couches métalliques 330 et les premiers éléments de collage annulaires 345 est réalisé en cuivre Cu, celui-ci peut comporter, comme illustré sur les figures 1 et 2A à 2D et sur une partie de sa surface, une couche 346 dite barrière afin d'éviter toute diffusion du cuivre Cu dans la couche de passivation 347. On notera que dans ce cas, les surfaces destinées à faire office de surface de collage sont dépourvues de couche barrière 346.

On notera qu'une telle couche barrière est également avantageuse dans le cas où au moins l'un parmi les premiers plots de contact 343,344, les couches métalliques 330 et les premiers éléments de collage annulaires 345 est réalisé en tungsten W ou en titane Ti.

La couche barrière peut être :
- dans le cas où au moins l'un parmi les premiers plots de contact 343,344, les couches métalliques 330 et les premiers éléments de collage annulaires 345 est réalisé en cuivre, réalisée en nitrure de titane TiN, en un alliage de titane tungsten TiW ou en nitrure de tantale TaN ;
- dans le cas où au moins l'un parmi les premiers plots de contact 343,344, les couches métalliques 330 et les premiers éléments de collage annulaires 345 est réalisé en tungstène W ou en titane Ti, réalisée en nitrure de titane TiN ou en un alliage de titane tungsten TiW.

Avec la couche de passivation 347, les plots de contact 343, 344, les trois premiers éléments de collage annulaires 345 et la couche métallique 330, le premier substrat 400 est adapté pour permettre le collage du deuxième substrat 200 comportant les structures de détection 10, les parois latérales 220 et le capot 210.

La fourniture du premier substrat 400 peut consister en les sous-étapes suivantes :
- fourniture d'un premier support semiconducteur 341,
- aménagement dans le premier support semiconducteur 341 du circuit de lecture 340 en faisant notamment appel à des techniques de lithographie classique pour l'homme du métier,
- formation selon un procédé de formation damascène des premiers plots de contact 343,344, des couches métalliques 330 et des premiers éléments de collage annulaires 345.

Bien entendu, si les plots de contact 343,344, les couches métalliques 330 et les premiers éléments de collage annulaires 345 sont préférentiellement formés par un procédé de formation damascène, d'autres techniques de lithographie connues de l'homme du métier sont également envisageables sans que l'on sorte du cadre de l'invention.

La figure 3 illustre ainsi le premier substrat 400 avant collage du deuxième substrat 200 pour la formation du dispositif de détection 1 illustré sur la figure 1.

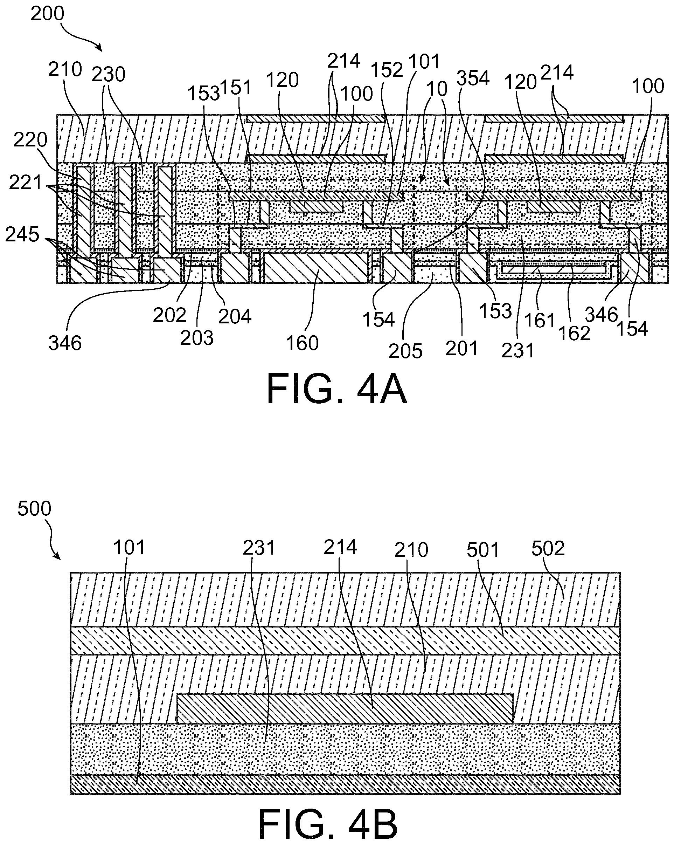

La figure 4A illustre le deuxième substrat 200 avant son collage sur le premier substrat 400.

Le deuxième substrat 200 comporte :
- le capot 210 comportant une première surface du deuxième substrat 200,
- les sous-parois 221 de la paroi latérale annulaire 220 s'étendant à partir du capot 210 et formant avec ce dernier une cavité 340 logeant les structures de détection 10, l'espace entre deux sous-parois 221 consécutives étant remplie d'un matériau de renfort 230, chacune des sous-paroi 221 étant munie, sur une extrémité opposée au capot 210 d'un deuxième élément de collage annulaire 245 complémentaire à un premier élément de collage annulaire 345 correspondant,
- un matériau sacrificiel 231 enfermant la structure de détection 10 et emplissant la cavité 235 formée par le capot 210 et la paroi latérale annulaire 220,
- une embase 201 comportant la deuxième surface du deuxième substrat 200, les deuxièmes plots de contact 153, 154 et les deuxièmes éléments de collage annulaires 245 étant chacun aménagé dans ladite embase 201 en étant exposé sur la deuxième surface du deuxième substrat 200.

Le capot 210 peut comporter en regard de chacune des structures de détection 10, comme illustré sur la figure 3, au moins une portion de surface traitée optiquement 214 ceci au moyen d'un traitement optique tel qu'un film antireflet ou une structuration de surface, afin de lui conférer des propriétés antireflet, ou un filtre afin de filtrer une partie du rayonnement électromagnétique comme par exemple la partie du rayonnement électromagnétique correspondant aux infrarouges lointains. Sur la figure 4A, le capot 210 comporte sur chacune de ces surfaces des portions de surface traitées optiquement 214 afin de lui conférer des propriétés antireflets.

Chacune des sous-parois 221 s'étend sensiblement perpendiculairement à partir du capot 210 suivant une ligne directrice courbe fermée ceci de manière à former avec le capot 210 une cavité 235 enfermant les structures de détection 10. Les sous-parois 221 s'emboîtent les unes avec les autres, avec la sous-paroi 221 la plus extérieure qui contient les autres sous-parois 221 et avec la sous-paroi 221 la plus intérieure qui est contenue par les autres sous-parois 221. Ainsi, les sous-parois 221 présentent une configuration en gigogne.

On peut noter que pour faciliter le collage de chaque deuxième éléments de collage annulaires 245 sur le premier élément de collage annulaire 345 correspondant, les lignes directrice courbes fermées des sous-parois 221 correspondent préférentiellement chacune à la ligne courbe fermée selon laquelle s'étend le premier élément de collage annulaire correspondant 345 du premier substrat 400. De cette manière, chacun des deuxièmes éléments de collage annulaires 245 peut s'étendre selon la même ligne directrice courbe fermée de la sous-paroi 221 correspondante sans que cela n'entrave le collage dudit deuxième élément de collage annulaire 245 sur le premier élément de collage annulaire 345 correspondant.

Les sous-parois 221 peuvent être formées dans un matériau sélectionné dans le groupe comportant le cuivre Cu, le tungstène W et le silicium Si, que celui-ci soit sous forme cristalline, polycristalline ou amorphe.

Le matériau de renfort 230 peut être le même matériau que matériau sacrificiel 231 enfermant la structure de détection et être réalisé en dioxyde de silicium Si0₂

L'embase 201 comporte, en partant d'une surface en regard du capot 210 dans la direction s'éloignant du capot 210 :
- une deuxième couche diélectrique 202,
- une troisième couche diélectrique 203 recouvrant la deuxième couche diélectrique 202,
- une couche d'arrêt 204 recouvrant la troisième couche diélectrique 203,
- une deuxième couche de passivation 205 recouvrant la couche d'arrêt 204, la deuxième couche de passivation 205 formant la deuxième surface du deuxième substrat 200.

Le matériau de la deuxième couche diélectrique 202 peut être sélectionné dans le groupe comprenant le nitrure de silicium Si₃N₄, le carbure de silicium amorphe hydrogéné aSiC:H, du carbure de silicium lié à du nitrure de silicium ou carbure de silicium nitruré, généralement connu sous la dénomination SiCN:H, et le carbone amorphe aC. L'épaisseur de la deuxième couche diélectrique 202 peut être comprise entre 100 et 20 nm, préférentiellement entre 70 et 30 nm et de manière particulièrement avantageuse entre 60 et 40 nm. L'épaisseur de la deuxième couche diélectrique 202 peut ainsi être sensiblement égale à 50 nm

Le matériau de la troisième couche diélectrique 203 peut être sélectionné dans le groupe comprenant le carbure de silicium lié à du nitrure de silicium ou carbure de silicium nitruré, généralement connu sous la dénomination SiCN:H, et le carbone amorphe aC. L'épaisseur de la troisième couche diélectrique 203 peut être comprise entre 100 et 20 nm, préférentiellement entre 70 et 30 nm et de manière particulièrement avantageuse entre 60 et 40 nm. L'épaisseur de la deuxième couche diélectrique 202 peut ainsi être sensiblement égale à 50 nm.

Le matériau de la couche d'arrêt 204 est un matériau adapté pour former une couche de protection lors d'une attaque sélective pour supprimer le matériau sacrificiel 231 et ainsi libérer la cavité 235 du matériau sacrificiel 231. Ainsi, selon une possibilité préférée selon laquelle le matériau sacrificiel 231 qui est un dioxyde de silicium SiOz, le matériau de la couche d'arrêt est préférentiellement sélectionné dans le groupe comportant l'alumine Al₂O₃ et le nitrure d'aluminium AIN.

La deuxième couche de passivation 205 est réalisée dans un matériau diélectrique qui est adapté pour un collage sur la première couche de passivation. Ainsi, la deuxième couche de passivation est préférentiellement réalisée dans le même matériau que celui de la première couche de passivation. La deuxième couche de passivation est avantageusement réalisée en dioxyde de silicium SiO₂

L'embase 201 comporte en outre les deuxièmes éléments de collage annulaires 245, les deuxièmes plots de contact 153, 154 et la surface de réflexion 160 qui s'étendent au travers de la troisième couche diélectrique 203, de la couche d'arrêt 204 et de la deuxième couche de passivation 205 en débouchant sur la deuxième surface du deuxième substrat 200. Les éléments de collage annulaires 245 sont agencés en contact avec les sous-parois 221 dans le prolongement de ces dernières de manière à assurer l'herméticité de la cavité 235. De la même façon, les deuxièmes plots de contact 153, 154 sont agencés en contact électrique avec le premier et le deuxième bras de connexion 151, 152 dans le prolongement de ces derniers.

Chacun des deuxièmes éléments de collage annulaires 245 est adapté pour autoriser un collage sur le premier élément de collage 345 correspondant du premier substrat 400. Une telle adaptation peut notamment être obtenue par la fourniture de chacun des deuxièmes éléments de collage annulaires 245 réalisé dans le même matériau que celui du premier élément de collage annulaire 345 correspondant. Afin d'autoriser une fermeture hermétique de la cavité 235 formée par le capot 210 et la paroi latérale annulaire 220, chacun des deuxièmes éléments de collage annulaires 245 s'étend selon une ligne directrice fermée sensiblement identique à la ligne directrice fermée selon laquelle s'étend le premier élément de collage annulaire 345 correspondant.

De la même façon, chacun des deuxièmes plots de contact 153, 154 est adapté pour autoriser un collage sur le premier plot de contact 343, 345 correspondant du premier substrat 400. Une telle adaptation peut notamment être obtenue par la fourniture de chacun des deuxièmes plots de contact 153, 154 réalisé dans le même matériau que celui du premier plot de contact 343, 344 correspondant. De manière identique, chacun des deuxièmes plots de contact 153, 154 présente selon un deuxième plan de collage défini par la deuxième surface du deuxième substrat 200, un dimensionnement sensiblement identique à celui du premier plot de collage 343, 344 selon un premier plan de collage défini par celui de la première surface du premier substrat 400.

La surface de réflexion 160 présente une adaptation, outre ses propriétés de réflexion, pour autoriser un collage sur la couche métallique 330. Une telle adaptation peut notamment être obtenue par la fourniture d'une surface de réflexion 160 réalisée dans le même matériau que celui de la couche métallique 330. La surface de réflexion 160 présente selon le deuxième plan de collage, un dimensionnement sensiblement identique à celui de la couche métallique 330selon le premier plan de collage.

Il est à noter que dans le cas où au moins l'un parmi les deuxième plots de contact, 153, 154, la surface de réflexion 160 et les deuxième éléments de collage 245 annulaires est réalisé en cuivre Cu, en titane Ti ou en tungstène W, celui-ci peut comporter, comme illustré sur les figures 1 et 2A à 2D sur une partie de sa surface une couche 346 dite barrière afin d'éviter toute diffusion du cuivre Cu, du titane Ti ou du tungstène W dans le reste de l'embase. On notera de plus que dans ce cas, les surfaces destinées à faire office de surface de collage sont dépourvues de couche barrière 346.

Une telle couche barrière est du même type que celle déjà décrite pour le premier substrat 400.

L'étape de fourniture du deuxième substrat 200 comporte les sous-étapes suivantes :
- fourniture d'un substrat du type semiconducteur sur isolant tel qu'illustré sur la figure 4B, le substrat 500 comportant un support, une couche d'isolant réalisé dans un matériau sacrificiel 231 et une couche semiconductrice 101, la couche semiconductrice 101 étant préférentiellement déplétée, le support comportant, en regard de la couche isolante une portion de surface traitée optiquement 214 correspondant chacune à une structure de détection 10, une seule portion de surface traitée optiquement 214 étant figurée sur la figure 4B,
- gravure localisée de la couche semiconductrice 101 afin de définir la couche semiconductrice 101 de chacune des structures de détection 10,
- implantation localisée d'élément dopant du premier type de conductivité, dans chacune des couches semiconductrices 101, d'une première et d'une deuxième zone semiconductrice 111, 112, les première et deuxième zone semiconductrice 111, 112 étant séparée l'une de l'autre par une troisième zone semiconductrice 113 non implantée, celle-ci étant ainsi déplétée,
- dépôt localisé d'une couche isolante 126 recouvrant au moins la troisième zone semiconductrice 113,
- dépôt localisé d'une couche d'absorption 125 en contact avec la couche isolante 126 et avec un agencement la rendant apte à polariser la troisième zone semiconductrice 113, la grille 120 étant ainsi formée,
- dépôt d'une couche de protection 122 recouvrant couche d'absorption 125 et les parties de la couche isolante 126 exposées,
- dépôt d'une première couche de matériau sacrificiel 231, la première couche de matériau sacrificiel 231 enfermant la couche semiconductrice 101, la couche isolante 126, la couche d'absorption 125 et la couche de protection 122,
- formation du premier et du deuxième bras de connexion 151, 152 comportant respectivement la première et la deuxième piste de connexion 162, 165 pour permettre la polarisation du transistor 100, la première piste de connexion 162 étant connectée à la deuxième zone semiconductrice 112, la deuxième piste de connexion 165 étant connectée à la première zone semiconductrice 111 et à la couche d'absorption 125 en les mettant en court-circuit,
- dépôt d'une deuxième couche de matériau sacrificiel 231, la deuxième couche de matériau sacrificiel 231 enfermant le premier et le deuxième bras de connexion 151, 152,
- dépôt de la deuxième couche de matériau diélectrique 202 en contact de la couches de matériau sacrificiel 231,
- formation des sous-parois 22A au travers de la couche de matériau diélectrique 202 et des première et deuxième couches de matériau sacrificiel 231, les sous-parois 221, et donc la paroi latérale annulaire 220 qu'elles forment, étant en contact avec le support 500 de manière à former avec le support 500 une cavité 235,
- dépôt de la troisième couche diélectrique 203 recouvrant la deuxième couche diélectrique 202,
- dépôt de la couche d'arrêt 204 recouvrant la troisième couche diélectrique 202,
- dans le cas où il prévu un matériau sorbeur 161 :
   ∘ dépôt localisé d'une deuxième couche de protection 162, tel que par exemple une couche de carbone amorphe de 50 nm d'épaisseur, sur au moins une portion de la couche d'arrêt 204 correspondant au matériau sorbeur 161, et
   ∘ dépôt du matériau sorbeur 161 en contact avec la troisième couche de protection au niveau de l'au moins une portion correspondant au matériau sorbeur 161,
- dépôt de la deuxième couche de passivation 205 recouvrant la couche d'arrêt et, le cas échéant, le matériau sorbeur 161, la couche d'arrêt 204, la deuxième couche de passivation 205 formant la deuxième surface du deuxième substrat 200.
- Formation les deuxièmes éléments de collage annulaires 245, les deuxièmes plots de contact et la surface de réflexion 160 au travers de la deuxième couche de passivation 205, de la couche d'arrêt 204 et de la troisième couche diélectrique 203, en débouchant respectivement sur les sous-parois 221, le premier et le deuxième bras de connexion 151, 152 et sur la couche d'arrêt.

Les sous-étapes de formation des sous-parois 221, des deuxièmes éléments de collage annulaires 245, des deuxièmes plots de contact 153, 154 et de la surface de réflexion 160 peuvent être une formation selon un procédé de formation damascène. Avantageusement, ces mêmes sous-étapes de formation des parois latérales annulaires 220, des deuxièmes éléments de collage annulaires 245, des deuxièmes plots de contact et de la surface de réflexion 160 peuvent comporter les opérations suivantes :
- aménagement des ouvertures annulaires correspondant chacune à l'une des sous-parois 221 dans la couche de matériau diélectrique 202 et les premières et deuxième couches de matériau sacrificiel 231,
- dépôt d'une couche de matériau barrière 346 en contact avec les parois desdites ouvertures,
- remplissage des ouvertures par le procédé de formation damascène afin de former les sous-parois 221 et donc la paroi latérale annulaire 220.

La sous-étape de formation des deuxièmes éléments de collage annulaires 245, des deuxièmes plots de contact 153, 154 et de la surface de réflexion 160 peut être mise en oeuvre avec des opérations du même type.

Il est également à noter que, comme le montre la figure 4A, les sous-étapes de formation du premier et du deuxième bras de connexion 151, 152 et de dépôt de la deuxième couche de matériau sacrificiel peuvent être réalisées en deux temps. Ainsi, la sous-étape de formation du premier et du deuxième bras de connexion 151, 152 peut comporter une première opération consistant à former une première portion des premier et deuxième bras de connexion 151, 152 et une deuxième opération consistant à former la deuxième portion. De même, la sous-étape de dépôt de la deuxième couche de matériau sacrificiel peut comprendre une opération de dépôt d'une première sous-couche de matériau sacrificiel enfermant la première portion du premier et du deuxième bras de connexion 151, 152 intermédiaire entre les opérations de formation du premier et deuxième bras de connexion 151, 152. La sous-étape de dépôt de la deuxième couche de matériau sacrificiel peut alors comprendre en outre une deuxième opération de dépôt d'une deuxième sous-couche de matériau sacrificiel enfermant la deuxième portion du premier et du deuxième bras de connexion 151, 152 postérieure aux opérations de formation du premier et deuxième bras de connexion 151, 152.

Dans le cadre de ce procédé, le capot 210 est formé par le support 500. Afin de fournir un capot 210 présentant une épaisseur optimisée, il peut être avantageusement prévu une étape d'amincissement du capot 210, c'est-à-dire du support 500. Ainsi, dans le cas où le support comporte, comme c'est le cas dans le présent mode de réalisation et comme illustré sur la figure 4B, une couche intermédiaire 501 pour arrêter la gravure, une telle étape d'amincissement peut comporter les sous-étapes suivantes :
- gravure de la partie 502 du support 500 opposée à la couche semiconductrice 101 sur isolant, la gravure étant stoppée au moyen de la couche intermédiaire 501,
- suppression de la couche intermédiaire 501, le reste du support 500 formant le capot 210 aminci.

De cette manière, il possible de contrôler précisément l'épaisseur du capot 210 après gravure

Avec une telle étape d'amincissement, il est possible de fournir un capot 210 présentant une épaisseur réduite afin d'optimiser la transmission du rayonnement électromagnétique au travers du capot 210. Ainsi, le capot 210, après l'étape d'amincissement peut présenter une épaisseur comprise entre 1 µm et 100 µm, préférentiellement comprise entre 5 µm et 50 µm et avantageusement entre 10 µm et 30 µm.

Bien entendu, une telle étape d'amincissement du capot 210, peut avoir lieu aussi bien dans le cadre de l'étape de fourniture du deuxième substrat 200 ou postérieurement à la fourniture du substrat 200.

Outre les étapes de fourniture du premier et du deuxième substrat déjà décrites, le procédé de formation d'un dispositif de détection 1 comporte les étapes suivantes :
- collage de la deuxième surface du deuxième substrat 200 sur la première surface du premier substrat 400 par un collage des deuxièmes éléments de collage annulaires 245 sur les premiers éléments de collage annulaires 345 et un collage des premiers plots de contact 153, 154 sur les deuxièmes plots de contact 343, 344,
- amincissement du support 500 afin de fournir un capot 210 avec une épaisseur contrôlée,
- aménagement d'au moins une ouverture dans le deuxième substrat 212,
- suppression sélective du matériau sacrificiel 231 correspondant aux première et deuxième couche de matériau sacrificiel 231, la suppression sélective permettant également de supprimer ou de rendre poreuses la deuxième couche diélectrique 202 et la troisième couche diélectrique 203,
- soumission de l'assemblage du premier et du deuxième substrat 400, 200 à une attaque adaptée pour supprimer la couche de protection 162 ceci afin de libérer la couche de matériau sorbeur 161.
- fermeture de ladite ouverture sous vide au moins primaire moyennant quoi le dispositif de détection 1 de rayonnements électromagnétiques est formé, ladite fermeture pouvant être réalisée au moyen d'un opercule 213, telle qu'illustrée sur la figure 1.

Dans le cas où, comme cela est illustré sur la figure 4A, il est prévu au niveau de la première surface du deuxième substrat 200 un traitement optique, il peut être prévu, après une éventuelle étape d'amincissement du capot 210, une étape d'application d'un traitement optique 214 sur les parties de la première surface du substrat 210 qui sont en regard d'une structure de détection 100. Bien entendu, comme illustré sur la figure 4B, il est également envisageable, ceci en variante ou en complément, que le support comporte en regard de la couche semiconductrice 101 sur isolant un traitement optique 214. Ainsi, dans le cas du deuxième substrat 200 illustré sur la figure 4A, il est prévu un traitement optique sur chacune des faces du capot ceci en regard de chacune des structures de détection 100.

Ainsi, l'étape de fourniture du deuxième substrat peut comporter une étape d'aménagement d'un traitement optique 214 sur l'une ou les deux faces du capot 210 ceci en regard d'au moins une structure 100. En alternative, ceci notamment pour un traitement optique sur la face du capot 210 qui est opposée à la structure optique, le procédé de fabrication peut comporter une étape d'aménagement d'un traitement optique 214.

Bien entendu, si de tels traitements optiques 214 sont avantageux dans le cadre de l'invention, un dispositif de détection 1 selon l'invention peut parfaitement être fonctionnel en étant exempt de tels traitements optiques.

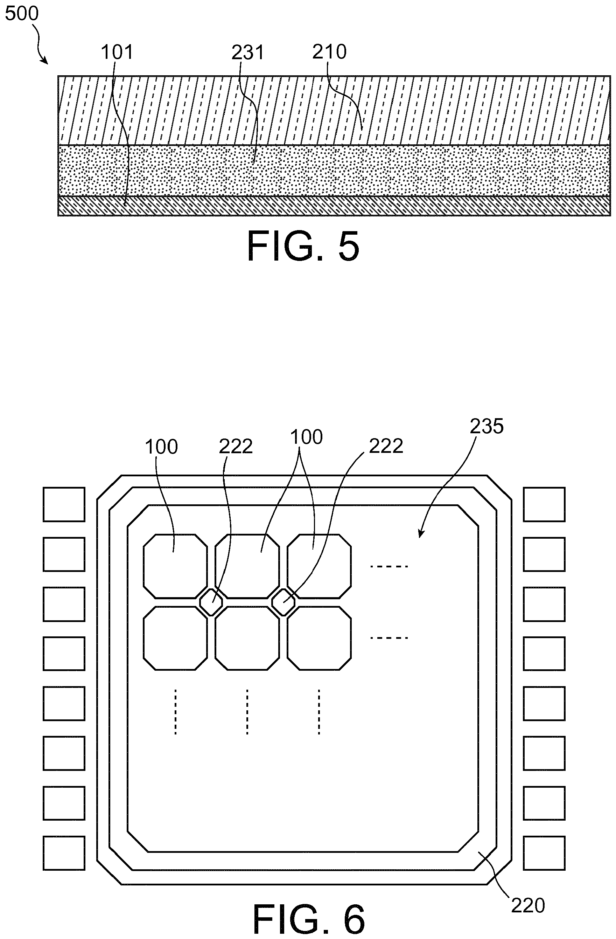

Ainsi, la figure 5 illustre un support 500 pour la formation d'un deuxième substrat 200 pour un dispositif de détection 1 selon un deuxième mode de réalisation dans lequel il n'est pas prévu de portion de surface traitée optiquement 214 et il n'est pas prévu de couche intermédiaire.

Un tel dispositif de détection 1 se différencie d'un dispositif selon le premier mode de réalisation en ce que le dispositif est dépourvu de portion de surface traitée optiquement 214 et en ce que lors de l'étape de fourniture du deuxième substrat, si une sous-étape d'amincissement du capot 210 est prévue, un tel amincissement n'utilise pas une couche intermédiaire afin de pouvoir contrôler l'épaisseur du capot 210.

La figure 6 illustre une vue schématique de dessus d'un dispositif de détection 1 selon le premier mode de réalisation, ladite figure 6 figurant l'agencement des structures et la possibilité de la fourniture de piliers de renfort 222 dans la cavité 235. De tels piliers de renfort 222 permettent de soutenir le capot afin de réduire, voire supprimer, les risques d'effondrement du capot 210.

De tels piliers de renfort 222 peuvent être positionnés entre les structures de détection avec une répartition régulière. Dans la configuration illustrée sur la figure 5, les piliers de renfort sont disposés à l'intersection entre quatre structures de détection 100. Bien entendu, une telle répartition n'est qu'indicative et est fournie qu'à titre d'exemple non limitatif.

Chaque pilier de renfort 222 peut présenter une configuration similaire à celle d'une sous-paroi 221 et être formé en cuivre Cu, en silicium Si ou en tungstène W avec une couche barrière 346, ou encore être formée par une paroi annulaire comprenant en son centre un matériau de renfort 230, tel que par exemple le matériau sacrificiel. Selon une autre possibilité de l'invention chaque pilier de renfort 222 peut être formé en silicium SiO₂.

Le procédé de fabrication d'un dispositif de détection 1 selon ce deuxième mode de réalisation se différencie d'un procédé de fabrication d'un dispositif de détection 1 selon le premier mode de réalisation en ce que lors de la sous étape de formation des sous-parois 220 il est également formé des piliers de renfort 222.

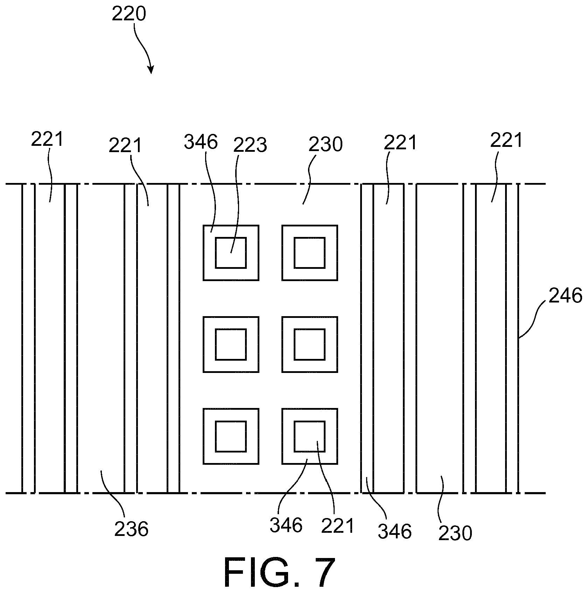

La figure 7 illustre un exemple de configuration de sous-parois 221 pour former la paroi latérale annulaire 220 en variante à celle présentée en lien avec la figure 1. Selon cette configuration, il est prévu quatre sous-parois 221, deux sous-parois 220 internes et deux sous-parois 221 externes. Les sous-parois 221 internes sont séparées des sous-parois 221 externes par un espace interne empli de matériau de renfort 230 et comprenant des piliers de renfort internes 223 présentant une configuration similaire aux piliers de renfort 222 aménagés dans la cavité 235.

Ainsi, un procédé de fabrication d'un dispositif de détection 1 selon cette variante de l'invention se différencie d'un procédé de fabrication d'un dispositif de détection 1 selon le premier mode de réalisation en ce que lors de la sous étape de formation des sous-parois 221 il est également formé des piliers de renfort internes 223 entre deux sous-parois 221.

Bien entendu, les configurations de la paroi latérale annulaire 220 décrites dans le cadre du premier mode de réalisation et de la variante ci-dessus ne sont données qu'à titre d'exemple et ne sont nullement limitatives. Ainsi, il est parfaitement envisageable que le dispositif de détection 1 ne soit d'une seul paroi latérale annulaire 220 monobloc ou encore trois parois latérales annulaires 220 dont deux sont séparées par des piliers de renfort internes 222 similaires à ceux décrits dans le cadre de la variante ci-dessus, ceci-sans que l'on sorte du cadre de l'invention.

Selon une variante de l'invention non illustrée, la paroi latérale annulaire 220 peut comporter au moins une sous-paroi discontinue, les discontinuités étant remplies de matériau de renfort et dimensionné de manière à limiter l'attaque du matériau de renfort se trouvant au niveau de ces discontinuités. Bien entendu, selon cette variante, il est également envisageable que la paroi latérale annulaire comporte deux sous-parois discontinue, ou plus, le matériau de renfort étant disposé à la fois dans l'espace formé entre les deux sous-parois et au niveau des discontinuités.

Bien entendu si dans les modes de réalisation décrits ci-dessus les parois latérales annulaires 220 forment avec le capot 210 une cavité logeant l'ensemble des structures de détection 10, il est également envisageable, sans que l'on sorte du cadre de l'invention, que ces mêmes parois forment une cavité individuelle logeant une seule structure de détection ou une cavité partiellement mutualisée logeant une seule partie des structures de détection 100. Selon ces deux possibilités, il est alors nécessaire de prévoir d'autres parois latérales annulaires 220 afin de former avec le capot 210 la ou les autres cavités logeant le reste des structures de détection 100.

## Revendications

1. Procédé de fabrication d'un dispositif de détection (1) de rayonnements électromagnétiques, le procédé de fabrication comprenant les étapes suivantes :
- fourniture d'un premier substrat (400), le premier substrat intégrant un circuit de lecture (340) et comportant une première et une deuxième surface, le premier substrat (400) comprenant en outre au moins deux premiers plots de contact (343, 344) reliés au circuit de lecture (340) et au moins un premier élément de collage annulaire (345) entourant les premiers plots de contact (343, 344), les premiers plots de contact (343, 344) et le premier élément de collage annulaire (345) étant chacun au moins en partie exposés sur la première surface du premier substrat,
- fourniture d'un deuxième substrat (200), le deuxième substrat (200) comprenant :
∘ une première et une deuxième surface du deuxième substrat (200),
∘ au moins une structure de détection (100), pour la détection de rayonnements électromagnétiques, munie d'au moins deux bras de connexion (151, 152) se prolongeant chacun par un deuxième plot de contact (153, 154) complémentaire à un premier plot de contact (343, 344) correspondant, les bras de connexion (151, 152) étant configurés pour isoler thermiquement la structure de détection (100) du reste du dispositif (1), soutenir la structure de détection (100) et permettre sa connexion électrique,
∘ un matériau sacrificiel enfermant, avec les deuxièmes plots de contact (153, 154), la structure de détection (100) et les premiers et deuxième bras de connexion (151, 152),
∘ un capot (210) comprenant la première surface du deuxième substrat (200),
∘ au moins une paroi latérale annulaire (220) s'étendant à partir du capot, la paroi latérale annulaire (220) formant avec le capot (210) une cavité (235) logeant la structure de détection et le matériau sacrificiel, la paroi latérale annulaire (220) étant munie, sur une extrémité opposée au capot (210), d'un deuxième élément de collage annulaire (245) complémentaire au premier élément de collage annulaire (345),
∘ une embase (201) comportant la deuxième surface du deuxième substrat (200) et fermant la cavité (235) formée par le capot (210) et l'au moins une paroi latérale annulaire (220), et telle que les deuxièmes plots de contact (153, 154) et le deuxième élément de collage annulaire (245) sont chacun au moins en partie inclus dans l'embase (201),
dans lequel les deuxièmes plots de contact (153, 154) et le deuxième élément de collage annulaire (245) sont chacun au moins en partie exposés sur la deuxième surface du deuxième substrat (200),
- collage de la deuxième surface du deuxième substrat (200) sur la première surface du premier substrat (400) par un collage du deuxième élément de collage annulaire (245) sur le premier élément de collage annulaire (345) et un collage des premiers plots de contact (343, 344) sur les deuxièmes plots de contact (153, 154),
- aménagement d'au moins une ouverture (212) dans le deuxième substrat (200),
- suppression sélective du matériau sacrificiel,
- fermeture de ladite ouverture (212) sous vide au moins primaire moyennant quoi le dispositif de détection (1) de rayonnements électromagnétiques est formé.

2. Procédé de fabrication selon la revendication 1 comportant en outre une étape d'amincissement du capot (210).

3. Procédé de fabrication selon l'une quelconque des revendications 1 ou 2 dans lequel la paroi latérale annulaire (220) comporte au moins une sous-paroi (221) réalisée dans un matériau sélectionné parmi le cuivre, le silicium et le tungstène.

4. Procédé de fabrication selon l'une quelconque des revendications 1 à 3, dans lequel la paroi latérale annulaire (220) comporte au moins une couche barrière adaptée pour contenir la diffusion d'une partie d'au moins un matériau constitutif de la paroi latérale annulaire (220), ladite couche barrière étant préférentiellement réalisée dans un matériau sélectionné parmi un nitrure de titane, un alliage de titane tungstène et un nitrure de tantale.

5. Procédé de fabrication selon la revendication 1 ou 2, dans lequel lors de l'étape de fourniture du premier substrat (400), il est prévu au moins deux premier éléments de collage annulaire (345) selon une configuration gigogne,
dans lequel lors de l'étape de fourniture du deuxième substrat (200), la paroi latérale annulaire (220) comprend au moins deux sous-parois (221) selon une configuration gigogne correspondant chacune à un premier élément de collage annulaire (345) respectif, chacune des sous-parois (221) comportant un deuxième élément de collage annulaire (245) correspondant audit premier élément de collage annulaire (345) respectif,
et dans lequel, lors de l'étape de collage de la deuxième surface du deuxième substrat (200) sur la première surface du premier substrat (400), chacun des deuxièmes éléments de collage annulaires (245) est collé sur le premier élément de collage annulaire (345) correspondant.

6. Procédé de fabrication selon la revendication 5, dans lequel lors de la fourniture du deuxième substrat (200), le capot (210) comporte en outre un matériau de renfort dans un espace entre les sous-parois (221).

7. Procédé de fabrication selon l'une quelconque des revendications 1 à 6, dans lequel lors des étapes de fourniture du premier et du deuxième substrat (400, 200) au moins l'un du premier et du deuxième substrat (400, 200) comporte au moins une couche de matériau sorbeur (161) avec un agencement adapté pour qu'après collage du deuxième substrat (200) sur le premier substrat (400) et la suppression sélective du matériau sacrificiel, ladite couche de matériau sorbeur (161) communique avec la cavité (235).

8. Procédé de fabrication selon l'une quelconque des revendications 1 à 7, dans lequel lors de l'étape de fourniture du deuxième substrat (200), la structure de détection (10) est un transistor (100) MOS-FET.

9. Procédé de fabrication selon la revendication 8, dans lequel l'étape de fourniture du deuxième substrat (200) comporte les sous-étapes suivantes :
- fourniture d'un substrat (500) du type couche semiconductrice sur isolant, le substrat du type couche semiconductrice sur isolant comprenant un support (501, 502, 210), une couche d'isolant formé d'un matériau sacrificiel (231) et une couche semiconductrice (101),
- suppression sélective d'une partie de la couche semiconductrice (101) afin de délimiter une portion de couche correspondant à la surface du transistor (100) MOS-FET,
- implantation localisée d'élément dopant d'un premier type de conductivité dans la portion de couches semiconductrices (101), d'une première et d'une deuxième zone semiconductrice (111, 112), les première et deuxième zones semiconductrices (111, 112) étant séparée l'une de l'autre par une troisième zone semiconductrice (113) non implantée,
- dépôt localisé d'une couche isolante (126) recouvrant au moins la troisième zone semiconductrice (113),
- dépôt localisé d'une couche d'absorption (125) en contact avec la couche isolante (126) avec un agencement rendant la couche d'absorption (125) apte à polariser la troisième zone semiconductrice (113),
- dépôt d'une couche de protection (122) recouvrant couche d'absorption (125) et les parties de la couche isolante (126) exposées,
- dépôt d'une première couche de matériau sacrificiel (231), la première couche de matériau sacrificiel (231) enfermant la couche semiconductrice (101), la couche isolante (126), la couche d'absorption (125) et la couche de protection (122),
- formation du premier et du deuxième bras de connexion (151, 152) comportant respectivement la première et la deuxième piste de connexion (162, 165) pour permettre la polarisation du transistor (100), la première piste de connexion (162) étant connectée à la deuxième zone semiconductrice (112), la deuxième piste de connexion (165) étant connectée à la première zone semiconductrice (111) et à la couche d'absorption (125) en les mettant en court-circuit,
- dépôt d'une deuxième couche de matériau sacrificiel (231), la deuxième couche de matériau sacrificiel (231) enfermant le premier et le deuxième bras de connexion (151, 152),
- dépôt de la deuxième couche de matériau diélectrique (202) en contact de la couche de matériau sacrificiel (231),
- formation de la paroi latérale annulaire (220) au travers de la couche de matériau diélectrique (202) et des première et deuxième couches de matériau sacrificiel (231), la paroi latérale annulaire (220) étant en contact avec le support (500) de manière à former avec le support (501, 502, 210) une cavité (235),
- formation du deuxième élément de collage annulaire (245) et des deuxièmes plots de contact(153, 154) de manière à former le deuxième substrat (200) ceci avec les deuxièmes plots de contact (153, 154) et le deuxième élément de collage annulaire (245) au moins en partie exposés sur la deuxième surface du deuxième substrat (200).

10. Procédé de fabrication selon la revendication 9, dans lequel lors de la sous-étape de fourniture d'un substrat (500) du type couche semiconductrice sur isolant de l'étape de fourniture du deuxième substrat, le support (501, 502, 210) comprend un traitement optique (214).

11. Dispositif de détection (1) de rayonnements électromagnétiques comprenant :
- un premier substrat (400), le premier substrat (400) intégrant un circuit de lecture (341) et comportant une première et une deuxième surface, le premier substrat (400) comprenant en outre au moins deux premiers plots de contact (343, 344) reliés au circuit de lecture et au moins un premier élément de collage annulaire (345) entourant les premiers plots de contact (343, 344), les premiers plots de contact (343, 344) et le premier élément de collage annulaire (345) étant chacun au moins en partie exposés sur la première surface du premier substrat (400),
- un deuxième substrat (200) comprenant :
∘ une première et une deuxième surface du deuxième substrat (200),
∘ au moins une structure de détection (100), pour la détection de rayonnements électromagnétiques, munie d'au moins deux bras de connexion (151, 152) se prolongeant chacun par un deuxième plot de contact (153, 154) complémentaires à un premier plot de contact correspondant, chacun des deuxièmes plots de contact (153, 154) étant collé au premier plot de contact (343, 344) correspondant, les bras de connexion (151, 152) étant configurés pour isoler thermiquement la structure de détection (100) du reste du dispositif (1), soutenir la structure de détection (100) et permettre sa connexion électrique,
∘ au moins un capot (210) comprenant la première surface du deuxième substrat (200),
ο au moins une paroi latérale annulaire (220) s'étendant à partir du capot (210) et formant avec le capot (210) une cavité logeant la structure de détection (100), la paroi latérale annulaire (220) étant munie, sur une extrémité opposée au capot (210), d'un deuxième élément de collage annulaire (245) complémentaire au premier élément de collage annulaire (345), le deuxième élément de collage annulaire (245) étant collé au premier élément de collage annulaire (345) avec le premier substrat (400), le capot (210) et la paroi latérale annulaire (220) participant à la formation d'une cavité (235) fermée logeant la structure de détection (100) et présentant un vide au moins primaire,
∘ une embase (201) comportant la deuxième surface du deuxième substrat (200) et fermant la cavité (235) formée par le capot (210) et l'au moins une paroi latérale annulaire (220), et telle que les deuxièmes plots de contact (153, 154) et le deuxième élément de collage annulaire (245) sont chacun au moins en partie inclus dans l'embase (201),
et dans lequel la deuxième surface du deuxième substrat (200) est collée à la première surface du premier substrat (400).

12. Dispositif de détection (1) selon la revendication 11, dans lequel le capot (210) présente une épaisseur comprise entre 1 µm et 100 µm, préférentiellement comprise entre 5 µm et 50 µm et avantageusement entre 10 µm et 30 µm

13. Dispositif de détection (1) selon la revendication 11 ou 12, dans lequel la paroi latérale annulaire (220) comporte au moins deux sous-parois (221) selon une configuration gigogne.

14. Dispositif de détection selon l'une quelconque des revendications 11 à 13, dans lequel la structure de détection (10) est un transistor (100) MOS-FET.

## Patentansprüche

1. Verfahren zur Herstellung einer Detektionsvorrichtung (1) für elektromagnetische Strahlungen, wobei das Herstellungsverfahren die folgenden Schritte umfasst:
- Bereitstellen eines ersten Substrats (400), wobei das erste Substrat eine Leseschaltung (340) integriert und eine erste und eine zweite Fläche umfasst, wobei das erste Substrat (400) weiter mindestens zwei erste Kontaktpads (343, 344), die an die Leseschaltung (340) angeschlossen sind, und mindestens ein erstes ringförmiges Klebeelement (345) umfasst, das die ersten Kontaktpads (343, 344) umgibt, wobei die ersten Kontaktpads (343, 344) und das erste ringförmige Klebeelement (345) jeweils mindestens zum Teil auf der ersten Fläche des ersten Substrats freiliegen,
- Bereitstellen eines zweiten Substrats (200), wobei das zweite Substrat (200) umfasst:
-- eine erste und eine zweite Fläche des zweiten Substrats (200),
-- mindestens eine Detektionsstruktur (100) zum Detektieren von elektromagnetischen Strahlungen, die mit mindestens zwei Verbindungsarmen (151, 152) ausgestattet ist, die sich jeweils mit einem zweiten Kontaktpad (153, 154) fortsetzen, das zu einem entsprechenden ersten Kontaktpad (343, 344) komplementär ist, wobei die Verbindungsarme (151, 152) so konfiguriert sind, dass sie die Detektionsstruktur (100) thermisch vom Rest der Vorrichtung (1) isolieren, die Detektionsstruktur (100) stützen und ihre elektrische Verbindung ermöglichen,
-- ein Opfermaterial, das zusammen mit den zweiten Kontaktpads (153, 154) die Detektionsstruktur (100) und den ersten und den zweiten Verbindungsarm (151, 152) umschließt,
-- eine Abdeckung (210), die die erste Fläche des zweiten Substrats (200) umfasst,
-- mindestens eine ringförmige Seitenwand (220), die sich von der Abdeckung ausgehend erstreckt, wobei die ringförmige Seitenwand (220) zusammen mit der Abdeckung (210) einen Hohlraum (235) bildet, der die Detektionsstruktur und das Opfermaterial aufnimmt, wobei die ringförmige Seitenwand (220) an einem der Abdeckung (210) gegenüberliegenden Ende mit einem zweiten ringförmigen Klebeelement (245) ausgestattet ist, das zum ersten ringförmigen Klebeelement (345) komplementär ist,
-- eine Basis (201), die die zweite Fläche des zweiten Substrats (200) umfasst und den von der Abdeckung (210) und der mindestens einen ringförmigen Seitenwand (220) gebildeten Hohlraum (235) verschließt, und zwar derart, dass die zweiten Kontaktpads (153, 154) und das zweite ringförmige Klebeelement (245) jeweils mindestens zum Teil in der Basis (201) eingeschlossen sind,
wobei die zweiten Kontaktpads (153, 154) und das zweite ringförmige Klebeelement (245) jeweils mindestens zum Teil auf der zweiten Fläche des zweiten Substrats (200) freiliegen,
- Kleben der zweiten Fläche des zweiten Substrats (200) auf die erste Fläche des ersten Substrats (400) durch ein Kleben des zweiten ringförmigen Klebeelements (245) auf das erste ringförmige Klebeelement (345) und ein Kleben der ersten Kontaktpads (343, 344) auf die zweiten Kontaktpads (153, 154),
- Ausgestalten mindestens einer Öffnung (212) im zweiten Substrat (200),
- selektives Entfernen des Opfermaterials,
- Verschließen der Öffnung (212) unter mindestens primärem Vakuum, wodurch die Detektionsvorrichtung (1) für elektromagnetische Strahlungen gebildet wird.

2. Herstellungsverfahren nach Anspruch 1, das weiter einen Schritt des Ausdünnens der Abdeckung (210) umfasst.

3. Herstellungsverfahren nach einem der Ansprüche 1 oder 2, wobei die ringförmige Seitenwand (220) mindestens eine Teilwand (221) umfasst, die aus einem Material, ausgewählt aus Kupfer, Silizium und Wolfram, besteht.

4. Herstellungsverfahren nach einem der Ansprüche 1 bis 3, wobei die ringförmige Seitenwand (220) mindestens eine Sperrschicht umfasst, die geeignet ist, die Diffusion eines Teils mindestens eines Materials, aus dem die ringförmige Seitenwand (220) besteht, einzudämmen, wobei die Sperrschicht vorzugsweise aus einem Material, ausgewählt aus einem Titannitrid, einer Titan-WolframLegierung und einem Tantalnitrid, besteht.

5. Herstellungsverfahren nach Anspruch 1 oder 2, wobei beim Schritt des Bereitstellens des ersten Substrats (400) mindestens zwei erste ringförmige Klebeelemente (345) in einer stapelartigen Konfiguration vorgesehen werden,
wobei beim Schritt des Bereitstellens des zweiten Substrats (200) die ringförmige Seitenwand (220) mindestens zwei Teilwände (221) in einer stapelartigen Konfiguration umfasst, die jeweils einem jeweiligen ersten ringförmigen Klebeelement (345) entsprechen, wobei jede derTeilwände (221) ein zweites ringförmiges Klebeelement (245) umfasst, das dem jeweiligen ersten ringförmigen Klebeelement (345) entspricht,
und wobei beim Schritt des Klebens der zweiten Fläche des zweiten Substrats (200) auf die erste Fläche des ersten Substrats (400) jedes der zweiten ringförmigen Klebeelemente (245) auf das entsprechende erste ringförmige Klebeelement (345) geklebt wird.

6. Herstellungsverfahren nach Anspruch 5, wobei beim Bereitstellen des zweiten Substrats (200) die Abdeckung (210) weiter ein Verstärkungsmaterial in einem Raum zwischen den Teilwänden (221) umfasst.

7. Herstellungsverfahren nach einem der Ansprüche 1 bis 6, wobei bei den Schritten des Bereitstellens des ersten und des zweiten Substrats (400, 200) mindestens eines des ersten und des zweiten Substrats (400, 200) mindestens eine Gettermaterialschicht (161) mit einer Anordnung umfasst, die geeignet ist, damit nach dem Kleben des zweiten Substrats (200) auf das erste Substrat (400) und dem selektiven Entfernen des Opfermaterials die Gettermaterialschicht (161) mit dem Hohlraum (235) kommuniziert.

8. Herstellungsverfahren nach einem der Ansprüche 1 bis 7, wobei beim Schritt des Bereitstellens des zweiten Substrats (200) die Detektionsstruktur (10) ein MOS-FET-Transistor (100) ist.

9. Herstellungsverfahren nach Anspruch 8, wobei der Schritt des Bereitstellens des zweiten Substrats (200) die folgenden Teilschritte umfasst:
- Bereitstellen eines Substrats (500) vom Typ Halbleiterschicht-auf-Isolator, wobei das Substrat vom Typ Halbleiterschicht-auf-Isolator einen Träger (501, 502, 210), eine aus einem Opfermaterial (231) gebildete Isolatorschicht und eine Halbleiterschicht (101) umfasst,
- selektives Entfernen eines Teils der Halbleiterschicht (101), um einen Schichtabschnitt zu begrenzen, der der Fläche des MOS-FET-Transistors (100) entspricht,
- lokalisiertes Implantieren eines Dotierungselements eines ersten Leitfähigkeitstyps in den Halbleiterschichtenabschnitt (101) eines ersten und eines zweiten Halbleiterbereichs (111, 112), wobei der erste und der zweite Halbleiterbereich (111, 112) durch einen nicht implantierten dritten Halbleiterbereich (113) voneinander getrennt sind,
- lokalisiertes Abscheiden einer Isolierschicht (126), die mindestens den dritten Halbleiterbereich (113) bedeckt,
- lokalisiertes Abscheiden einer Absorptionsschicht (125) in Kontakt mit der Isolierschicht (126) mit einer Anordnung, die die Absorptionsschicht (125) in die Lage versetzt, den dritten Halbleiterbereich (113) zu polarisieren,
- Abscheiden einer Schutzschicht (122), die die Absorptionsschicht (125) und die freiliegenden Teile der Isolierschicht (126) bedeckt,
- Abscheiden einer ersten Opfermaterialschicht (231), wobei die erste Opfermaterialschicht (231) die Halbleiterschicht (101), die Isolierschicht (126), die Absorptionsschicht (125) und die Schutzschicht (122) umschließt,
- Bilden des ersten und des zweiten Verbindungsarms (151, 152), die jeweils die erste und die zweite Verbindungsbahn (162, 165) umfassen, um das Polarisieren des Transistors (100) zu ermöglichen, wobei die erste Verbindungsbahn (162) mit dem zweiten Halbleiterbereich (112) verbunden wird, wobei die zweite Verbindungsbahn (165) mit dem ersten Halbleiterbereich (111) und mit der Absorptionsschicht (125) verbunden wird, indem diese kurzgeschlossen werden,
- Abscheiden einer zweiten Opfermaterialschicht (231), wobei die zweite Opfermaterialschicht (231) den ersten und den zweiten Verbindungsarm (151, 152) umschließt,
- Abscheiden der zweiten dielektrischen Materialschicht (202) in Kontakt mit der Opfermaterialschicht (231),
- Bilden der ringförmigen Seitenwand (220) durch die dielektrische Materialschicht (202) und die erste und die zweite Opfermaterialschicht (231), wobei sich die ringförmige Seitenwand (220) mit dem Träger (500) in Kontakt befindet, um zusammen mit dem Träger (501, 502, 210) einen Hohlraum (235) zu bilden,
- Bilden des zweiten ringförmigen Klebeelements (245) und der zweiten Kontaktpads (153, 154), um das zweite Substrat (200) zu bilden, wobei die zweiten Kontaktpads (153, 154) und das zweite ringförmige Klebeelement (245) mindestens zum Teil auf der zweiten Fläche des zweiten Substrats (200) freiliegen.

10. Herstellungsverfahren nach Anspruch 9, wobei beim Teilschritt des Bereitstellens eines Substrats (500) vom Typ Halbleiterschicht-auf-Isolator aus dem Schritt des Bereitstellens des zweiten Substrats der Träger (501, 502, 210) eine optische Bearbeitung (214) umfasst.

11. Detektionsvorrichtung (1) für elektromagnetische Strahlungen, umfassend:
- ein erstes Substrat (400), wobei das erste Substrat (400) eine Leseschaltung (341) integriert und eine erste und eine zweite Fläche umfasst, wobei das erste Substrat (400) weiter mindestens zwei erste Kontaktpads (343, 344), die an die Leseschaltung angeschlossen sind, und mindestens ein erstes ringförmiges Klebeelement (345) umfasst, das die ersten Kontaktpads (343, 344) umgibt, wobei die ersten Kontaktpads (343, 344) und das erste ringförmige Klebeelement (345) jeweils mindestens zum Teil auf der ersten Fläche des ersten Substrats (400) freiliegen,
- ein zweites Substrat (200), umfassend:
-- eine erste und eine zweite Fläche des zweiten Substrats (200),
-- mindestens eine Detektionsstruktur (100) zum Detektieren von elektromagnetischen Strahlungen, die mit mindestens zwei Verbindungsarmen (151, 152) ausgestattet ist, die sich jeweils mit einem zweiten Kontaktpad (153, 154) fortsetzen, das zu einem entsprechenden ersten Kontaktpad komplementär ist, wobei jedes der zweiten Kontaktpads (153, 154) an das entsprechende erste Kontaktpad (343, 344) geklebt ist, wobei die Verbindungsarme (151, 152) so konfiguriert sind, dass sie die Detektionsstruktur (100) thermisch vom Rest der Vorrichtung (1) isolieren, die Detektionsstruktur (100) stützen und ihre elektrische Verbindung ermöglichen,
-- mindestens eine Abdeckung (210), die die erste Fläche des zweiten Substrats (200) umfasst,
-- mindestens eine ringförmige Seitenwand (220), die sich von der Abdeckung (210) ausgehend erstreckt und zusammen mit der Abdeckung (210) einen Hohlraum bildet, der die Detektionsstruktur (100) aufnimmt, wobei die ringförmige Seitenwand (220) an einem der Abdeckung (210) gegenüberliegenden Ende mit einem zweiten ringförmigen Klebeelement (245) ausgestattet ist, das zum ersten ringförmigen Klebeelement (345) komplementär ist, wobei das zweite ringförmige Klebeelement (245) an das erste ringförmige Klebeelement (345) mit dem ersten Substrat (400) geklebt ist, wobei die Abdeckung (210) und die ringförmige Seitenwand (220) an der Bildung eines geschlossenen Hohlraums (235) mitwirken, der die Detektionsstruktur (100) aufnimmt und ein mindestens primäres Vakuum aufweist,
-- eine Basis (201), die die zweite Fläche des zweiten Substrats (200) umfasst und den von der Abdeckung (210) und der mindestens einen ringförmigen Seitenwand (220) gebildeten Hohlraum (235) verschließt, und zwar derart, dass die zweiten Kontaktpads (153, 154) und das zweite ringförmige Klebeelement (245) jeweils mindestens zum Teil in der Basis (201) eingeschlossen sind,
und wobei die zweite Fläche des zweiten Substrats (200) an die erste Fläche des ersten Substrats (400) geklebt ist.

12. Detektionsvorrichtung (1) nach Anspruch 11, wobei die Abdeckung (210) eine Dicke im Bereich zwischen 1 µm und 100 µm, vorzugsweise im Bereich zwischen 5 µm und 50 µm und vorteilhafterweise zwischen 10 µm und 30 µm, aufweist.

13. Detektionsvorrichtung (1) nach Anspruch 11 oder 12, wobei die ringförmige Seitenwand (220) mindestens zwei Teilwände (221) in einer stapelartigen Konfiguration umfasst.

14. Detektionsvorrichtung nach einem der Ansprüche 11 bis 13, wobei die Detektionsstruktur (10) ein MOS-FET-Transistor (100) ist.

## Claims

1. Method for manufacturing a device (1) for detecting electromagnetic radiation, the manufacturing method comprising the following steps:
- providing a first substrate (400), the first substrate integrating a reading circuit (340) and including a first and a second surface, the first substrate (400) further comprising at least two first bump contacts (343, 344) connected to the reading circuit (340) and at least one first annular bonding element (345) surrounding the first bump contacts (343, 344), the first bump contacts (343, 344) and the first annular bonding element (345) each being at least partly exposed on the first surface of the first substrate,
- providing a second substrate (200), the second substrate (200) comprising:
-- a first and a second surface of the second substrate (200),
-- at least one detection structure (100), for the detection of electromagnetic radiation, provided with at least two connection arms (151, 152) each extended by a second bump contact (153, 154) complementary to a corresponding first bump contact (343, 344), the connection arms (151, 152) being configured to thermally insulate the detection structure (100) from the rest of the device (1), support the detection structure (100) and allow its electric connection,
-- a sacrificial material enclosing, with the second bump contacts (153, 154), the detection structure (100) and the first and second connection arms (151, 152),
-- a cover (210) comprising the first surface of the second substrate (200),
-- at least one annular lateral wall (220) extending from the cover, the annular lateral wall (220) forming with the cover (210) a cavity (235) housing the detection structure and the sacrificial material, the annular lateral wall (220) being provided, on an end opposite to the cover (210), with a second annular bonding element (245) complementary to the first annular bonding element (345),
-- a base (201) including the second surface of the second substrate (200) and enclosing the cavity (235) formed by the cover (210) and the at least one annular lateral wall (220), and such that the second bump contacts (153, 154) and the second annular bonding element (245) are each at least partly included in the base (201),
wherein the second bump contacts (153, 154) and the second annular bonding element (245) are each at least partly exposed on the second surface of the second substrate (200),
- bonding the second surface of the second substrate (200) onto the first surface of the first substrate (400) by a bonding of the second annular bonding element (245) onto the first annular bonding element (345) and a bonding of the first bump contacts (343, 344) onto the second bump contacts (153, 154),
- making at least one opening (212) in the second substrate (200),
- selectively removing the sacrificial material,
- closing said opening (212) under at least primary vacuum whereby the device (1) for detecting electromagnetic radiation is formed.

2. Manufacturing method according to claim 1, further including a step of thinning the cover (210).

3. Manufacturing method according to any one of claims 1 or 2, wherein the annular lateral wall (220) includes at least one sub-wall (221) made of a material selected from copper, silicon and tungsten.

4. Manufacturing method according to any one of claims 1 to 3, wherein the annular lateral wall (220) includes at least one barrier layer adapted to contain the diffusion of a part of at least one material forming the annular lateral wall (220), said barrier layer preferably being made of a material selected from a titanium nitride, a titanium tungsten alloy and a tantalum nitride.

5. Manufacturing method according to claim 1 or 2, wherein during the step of providing the first substrate (400), at least two first annular bonding elements (345) are provided according to a nested configuration,
wherein during the step of providing the second substrate (200), the annular lateral wall (220) comprises at least two sub-walls (221) according to a nested configuration each corresponding to a first respective annular bonding element (345), each of the sub-walls (221) including a second annular bonding element (245) corresponding to said first respective annular bonding element (345),
and wherein, during the step of bonding the second surface of the second substrate (200) onto the first surface of the first substrate (400), each of the second annular bonding elements (245) is bonded onto the corresponding first annular bonding element (345).

6. Manufacturing method according to claim 5, wherein during the providing of the second substrate (200), the cover (210) further includes a reinforcing material in a space between the sub-walls (221).

7. Manufacturing method according to any one of claims 1 to 6, wherein during the steps of providing the first and the second substrate (400, 200), at least one of the first and the second substrate (400, 200) includes at least one layer of getter material (161) with an arrangement adapted so that after bonding of the second substrate (200) onto the first substrate (400) and the selective removal of the sacrificial material, said layer of getter material (161) communicates with the cavity (235).

8. Manufacturing method according to any one of claims 1 to 7, wherein during the step of providing the second substrate (200), the detection structure (10) is a MOS-FET transistor (100).

9. Manufacturing method according to claim 8, wherein the step of providing the second substrate (200) includes the following sub-steps:
- providing a substrate (500) of the semiconductor on insulator layer type, the substrate of the semiconductor on insulator layer type comprising a support (501, 502, 210), a layer of insulator formed by a sacrificial material (231) and a semiconductor layer (101),
- selectively removing a part of the semiconductor layer (101) in order to define a layer portion corresponding to the surface of the MOS-FET transistor (100),
- locally implanting a doping element having a first type of conductivity in the portion of semiconductor layers (101), of a first and of a second semiconductor zone (111, 112), the first and second semiconductor zones (111, 112) being separated from one another by a third non-implanted semiconductor zone (113),
- locally depositing an insulating layer (126) covering at least the third semiconductor layer (113),
- locally depositing an absorption layer (125) in contact with the insulating layer (126) with an arrangement making the absorption layer (125) capable of polarising the third semiconductor zone (113),
- depositing a protective layer (122) covering the absorption layer (125) and the exposed parts of the insulating layer (126),
- depositing a first layer of sacrificial material (231), the first layer of sacrificial material (231) enclosing the semiconductor layer (101), the insulating layer (126), the absorption layer (125) and the protective layer (122),
- forming the first and the second connection arms (151, 152) respectively including the first and the second connection track (162, 165) to allow the polarisation of the transistor (100), the first connection track (162) being connected to the second semiconductor zone (112), the second connection track (165) being connected to the first semiconductor zone (111) and to the absorption layer (125) by short-circuiting them,
- depositing a second layer of sacrificial material (231), the second layer of sacrificial material (231) enclosing the first and the second connection arms (151, 152),
- depositing the second layer of dielectric material (202) in contact with the layer of sacrificial material (231),
- forming the annular lateral wall (220) through the layer of dielectric material (202) and the first and second layers of sacrificial material (231), the annular lateral wall (220) being in contact with the support (500) so as to form with the support (501, 502, 210) a cavity (235),
- forming the second annular bonding element (245) and the second bump contacts (153, 154) so as to form the second substrate (200), with the second bump contacts (153, 154) and the second annular bonding element (245) at least partly exposed on the second surface of the second substrate (200).

10. Manufacturing method according to claim 9, wherein during the substep of providing a substrate (500) of the semiconductor on insulator layer type of the step of providing the second substrate, the support (501, 502, 210) comprises an optical treatment (214).

11. Device (1) for detecting electromagnetic radiation, comprising:
- a first substrate (400), the first substrate (400) integrating a reading circuit (341) and including a first and a second surface, the first substrate (400) further comprising at least two first bump contacts (343, 344) connected to the reading circuit and at least one first annular bonding element (345) surrounding the first bump contacts (343, 344), the first bump contacts (343, 344) and the first annular bonding element (345) each being at least partly exposed on the first surface of the first substrate (400),
- a second substrate (200) comprising:
-- a first and a second surface of the second substrate (200),
-- at least one detection structure (100), for the detection of electromagnetic radiation, provided with at least two connection arms (151, 152) each extended by a second bump contact (153, 154) complementary to a corresponding first bump contact, each of the second bump contacts (153, 154) being bonded to the corresponding first bump contact (343, 344), the connection arms (151, 152) being configured to thermally insulate the detection structure (100) from the rest of the device (1), support the detection structure (100) and allow its electric connection,
-- at least one cover (210) comprising the first surface of the second substrate (200),
-- at least one annular lateral wall (220) extending from the cover (210) and forming with the cover (210) a cavity housing the detection structure (100), the annular lateral wall (220) being provided, on an end opposite to the cover (210), with a second annular bonding element (245) complementary to the first annular bonding element (345), the second annular bonding element (245) being bonded to the first annular bonding element (345) with the first substrate (400), the cover (210) and the annular lateral wall (220) participating in the formation of a closed cavity (235) housing the detection structure (100) and having an at least primary vacuum,
-- a base (201) including the second surface of the second substrate (200) and closing the cavity (235) formed by the cover (210) and the at least one annular lateral wall (220), and such that the second bump contacts (153, 154) and the second annular bonding element (245) are each at least partly included in the base (201),
and wherein the second surface of the second substrate (200) is bonded to the first surface of the first substrate (400).

12. Detection device (1) according to claim 11, wherein the cover (210) has a thickness of between 1µm and 100µm, preferably between 5µm and 50µm and advantageously between 10µm and 30µm.

13. Detection device (1) according to claim 11 or 12, wherein the annular lateral wall (220) includes at least two sub-walls (221) according to a nested configuration.

14. Detection device according to any one of claims 11 to 13, wherein the detection structure (10) is a MOS-FET transistor (100).
